Europäisches Patentamt

European Patent Office

Office européen des brevets

(19)

(11) Publication number: **0 335 683 B1**

# EUROPEAN PATENT SPECIFICATION

(12)

(45) Date of publication of patent specification: **20.10.93**

(51) Int. Cl.⁵: **C25D 3/56**, C25D 5/10

(21) Application number: **89303099.9**

(22) Date of filing: **29.03.89**

(54) **Electroplated alloy coatings having stable alloy composition.**

(30) Priority: **01.04.88 US 176805**
**29.04.88 US 188557**

(43) Date of publication of application:
**04.10.89 Bulletin 89/40**

(45) Publication of the grant of the patent:
**20.10.93 Bulletin 93/42**

(84) Designated Contracting States:
**AT BE CH DE FR GB IT LI LU NL SE**

(56) References cited:
EP-A- 0 329 877          US-A- 3 206 383
US-A- 3 467 584          US-A- 4 358 352
US-A- 4 463 060          US-A- 4 743 346

(73) Proprietor: **E.I. DU PONT DE NEMOURS AND COMPANY**
**1007 Market Street**
**Wilmington Delaware 19898(US)**

(72) Inventor: **Graham, Arthur Hughes**
**24 Dogwood Hill Road**
**Chadds Ford Pennsylvania 19317(US)**
Inventor: **Keating, Kenneth Bernard**
**1404 Stoneleigh Road**
**Delaware 19803(US)**

(74) Representative: **Barnard, Eric Edward et al**
**BROOKES & MARTIN**
**High Holborn House**
**52/54 High Holborn**
**London WC1V 6SE (GB)**

EP 0 335 683 B1

## Description

This invention relates to coatings of electroplated palladium-nickel alloys and in particular to such electroplated alloy coatings resulting from a plating bath process which controls the stability of the alloy composition in such coatings over a wide variation of electroplating current densities.

Gold has historically been the plating material of choice for electrical contacts because of its resistance to corrosion, good solderability properties and low electrical contact resistance at low loads. Since gold platings are expensive, lower cost substitutes have been sought.

Alloys of palladium-nickel have shown much promise as a gold substitute for plating electrical contacts. One of the more successful such palladium-nickel coatings is described in U.S. Patent 4,463,060.

The palladium-nickel electroplated surface coating described in this patent effectively protects the substrate from corrosion, is permanently solderable and exhibits reduced electrical contact resistance at low loads.

The coatings in the aforenoted 4,463,060 patent are prepared by electroplating in a bath of palladium (II) ammine chloride, nickel ammine sulfate, a small amount of brighteners, and a conductive salt. Electroplating is carried out at a current density ranging from about 5 to 25 A/dm$^2$. At current densities in the upper portion of this range, above about 1100 Am$^{-2}$ (100 asf), the Pd-Ni composition of the plated coating can be fairly readily controlled. As current densities decrease below this level, controlling the alloy composition becomes increasingly difficult.

Controlling the Pd-Ni alloy composition during electroplating is extremely important. The properties of Pd-Ni alloy coatings which are important for electronic connector applications, such as solderability, ductility, hardness, thermal stability of contact resistance and environmental corrosion resistance, vary significantly with fluctuation in electroplated alloy composition. Accurate control of the level and constancy of plated Pd-Ni alloy composition is therefore necessary to assure the desired properties of connector products.

Other plated connector performance criteria, such as absence of porosity and wear life, are strong functions of the precious metal alloy thickness. All widely used, nondestructive, production techniques for measurement of precious metal alloy coating thickness, such as electron backscatter spectroscopy and x-ray fluorescence, must be standardized for a specific alloy composition. Therefore, in the production of Pd-Ni alloy plated connector products, the stability of the alloy composition is also necessary to achieve the desired control of alloy coating thickness and the properties that are thickness-dependent.

Of particular concern is the stability of the alloy composition as a function of current density. In the commercial plating of formed terminals, there can be variations in current density as high as a factor of four depending upon location on the connector. The magnitude of the current density variation is dependent upon the part geometry, the plating cell design, and other factors. A typical range of current densities for most formed terminals is 275-1100 Am$^{-2}$ (25-100 asf). Locations on a few terminals might be plated as low as 110 Am$^{-2}$ (10 asf) or as high as 1650 Am$^{-2}$ (150 asf).

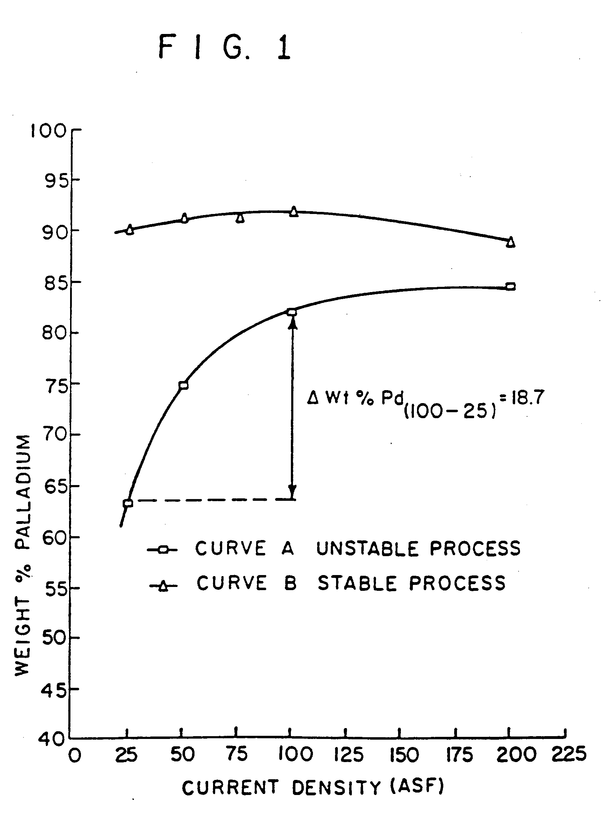

The effects of current density variation upon alloy composition stability can be better explained with reference to Figure 1 and Examples 1-3 below. For the purpose of this invention, the stability parameter for evaluation of Pd-Ni alloy plating process performance is defined as the difference between the Pd content in weight percent of an alloy deposited at 1100 Am$^{-2}$ (100 asf) and that for an alloy deposited at 275 Am$^{-2}$ (25 asf). This difference, which is illustrated for Curve A on Figure 1, will be referred to and indicated by the symbol $\Delta$ Wt% Pd$_{(100-25)}$. Plating baths formulated with typical commercially available palladium ammine chloride salts and organic brightener systems have a $\Delta$ Wt% Pd$_{(100-25)}$ in the approximate range of 12 to 22 as shown in Examples 1, 2, and 3. In Example 1, identical plating runs with respect to bath chemistry and plating conditions were conducted with palladous ammine dichloride salts from six different commercial sources. The $\Delta$ Wt% Pd$_{(100-25)}$ for these runs ranged from 13.0 to 18.7, indicating that they were all unstable with respect to the desired constancy of alloy composition.

In the preferred embodiments of this invention, the palladium-nickel alloy plating baths have $\Delta$ Wt% Pd$_{(100-25)}$'s in the range of 0 to 6. This is based upon the discovery that the intentional addition of iodate ions to palladium-nickel alloy plating baths results in a pronounced improvement in process stability as indicated by a significant decrease in the $\Delta$ Wt% Pd$_{(100-25)}$ parameter. . Moreover, additions of iodate ions alone or together with iodide ions, will result in an electroplated coating wherein a thin layer containing iodide forms on the surface of the plated palladium-nickel alloy and plays an important role in maintaining the constancy of the alloy composition during plating. Purification of palladium salts to remove certain chemical species that promote instability is also important and is necessary to achieve the ultimate in stability [$\Delta$ Wt% Pd$_{(100-25)}$ = 0].

The current density on the conductive substrate may vary by as much as a factor of four.

Description of the Drawings

Figure 1 is a graph illustrating the effects of current density variation upon Pd-Ni alloy composition stability, wherein Curve A represents plating run V of Example 1 and Curve B illustrates the beneficial effects of a 15 ppm iodide addition.

Figure 2 is a schematic illustrating a possible mechanism at the electrode interface which may contribute to the constancy effect on the Pd-Ni alloy composition, and shows the presence of iodide at the surface of the electroplated alloy.

Figure 3 confirms the presence of iodide in a thin surface layer of the electroplated alloy by X-ray photoelectron spectroscopy (XPS) analysis of the as-plated surface.

As noted above, the addition of iodate ions alone or in the presence of iodide ions to the palladium-nickel alloy plating bath has a pronounced effect on controlling the plated alloy composition. This is demonstrated by a significant decrease in the $\Delta$ Wt% $Pd_{(100-25)}$ parameter.

Iodide ions act as a brightener when added to a palladium-nickel alloy plating bath containing no organic additives. The iodide ion addition not only results in the plating of a mirror bright coating, but it also increases the maximum current density for the deposition of smooth, dense, nonporous coatings.

Additions of small amounts of iodate ions will significantly reduce $\Delta$ Wt% $Pd_{(100-25)}$. For example, the addition of as little as 15 ppm of iodate ion to a palladium-nickel alloy plating bath containing an organic brightener such as sodium vinyl sulfonate as described in Example 6 will reduce the $\Delta$ Wt% $Pd_{(100-25)}$ stability parameter from 16.7 to 7.8. When the amount of iodate ions added is raised to 100 ppm, the stability parameter is reduced further to 4.2 in Example 6. When no organic brightener is used, such as in the bath of Example 7, additions of 15 ppm and 100 ppm of iodate ions reduce the $\Delta$ Wt% $Pd_{(100-25)}$ stability parameter to 7.6 and 7.8, respectively. Moreover, as with iodide ion addition, the iodate ions also appear to act as a brightener since the coatings of Example 7 all have a bright, mirror-like appearance.

For palladium-nickel alloy plating processes based on certain organic brighteners, such as aliphatic sulfonic acids, the addition of small amounts of iodide ion is very effective in promoting process stability.

For palladium-nickel alloy plating processes based on other organic brighteners such as quaternized pyridines, larger additions of iodide ions are required to improve process stability. Technical grade N-benzyl niacin internal salt can be used as brightener. This salt is CAS Registry No. 15990-43-3 - pyridinium 3-carboxy-1-(phenylmethyl)hydroxide inner salt, and will be referred to subsequently as "pyridinium salt." The addition of 300 ppm of iodide ion decreased the $\Delta$ Wt% $Pd_{(100-25)}$ for this process from 16.9 to 11.7. Additional improvements in the constancy of the alloy composition plated by this process could be achieved by decreasing the concentration of "pyridinium salt" and by the removal of impurities in the brightener, some of which might be promoting instability.

The effect of palladium salt purification is shown by Example 4, below. Palladium salts used in Example 4 were purified by utilizing the fact that palladium diammine chloride, $Pd(NH_3)_2Cl_2$, is insoluble in water and will form a precipitate when a solution of palladium tetrammine chloride is treated with an excess of hydrochloric acid, as per the following reaction:

$$Pd(NH_3)_4Cl_2 + HCl \rightarrow 1/2\ Pd(NH_3)_2Cl_2 + 1/2\ H_2PdCl_4 + 3NH_3$$

Ammonia is liberated and chloropalladous acid is formed.

Palladium diammine chloride, however, can be solubilized by treating with ammonia (dissolving in $NH_4OH$), as follows:

$$Pd(NH_3)_2Cl_2 + 2NH_3 \rightarrow Pd(NH_3)_4Cl_2$$

Palladium tetrammine chloride salt is readily solubilized in water.

Thus, to purify further a purchased palladium tetrammine salt, the following procedure was used:

a) Dissolve the palladium tetrammine salt, $Pd(NH_3)_4Cl_2$, in deionized water.

b) Precipitate the palladium diammine chloride, $Pd(NH_3)_2Cl_2$, by adding an excess of hydrochloric acid.

c) Filter the precipitate from the mother liquor and wash several times with deionized water.

d) Redissolve the precipitated palladium diammine chloride in $NH_4OH$, again forming a solution of palladium tetrammine chloride.

To purify further a purchased palladium diammine chloride salt, the procedure was as follows:

a) Dissolve the palladium diammine chloride salt in $NH_4OH$, forming a solution of the palladium tetrammine chloride.

b) Precipitate the diammine chloride by adding an excess of hydrochloric acid.

c) Filter the precipitated palladium diammine from the mother liquor and wash several times with deionized water.

Based on the above, one cycle of purification is defined as the series of steps which will repeat the chemical identity of the original entity treated (e.g., palladium diammine chloride back to palladium diammine chloride). A palladium balance made on this series of steps verified the above stoichiometry.

It is well known to those skilled in the art of chemical synthesis that precipitation (recrystallization) will tend to purify the precipitated product, rejecting impurities to the supernatant mother liquor. Besides this method of purification, other methods of purification will suggest themselves to those skilled in the art, such as reaction of an aqueous solution of the palladium salt with hydrogen peroxide (especially for organic impurities), or passing the palladium solution through a bed of palladium powder, carbon treatment, etc. It should be noted that some purification methods may also remove the iodide ions as well as the undesired impurities which promote instability. In such cases, iodide ions must be added to the requisite concentration after purification. Strict control of the impurity content of all other ingredients of the palladium-nickel bath is also necessary.

Example 4 also shows the powerful effect of purification by precipitation as described above combined with the addition of iodide to the palladium-nickel plating bath. A one-cycle purification of a palladous tetrammine chloride salt, formulated into a plating bath with the addition of 31 ppm iodide ion resulted in a $\Delta Pd_{(100-25)}$ of 4.2. When a similar plating bath was formulated with a palladous tetrammine chloride salt purified through two cycles of purification (35 ppm iodide added) $\Delta Pd_{(100-25)}$ was 0.4, essentially a constant alloy composition over the current density range of 275-1100 $Am^{-2}$ (25 asf to 100 asf.)

The present invention has broad applicability with respect to all palladium-nickel alloy plating processes. The effectiveness of iodide additions in establishing constancy of plated alloy composition in the range of current densities from 275-1100 $Am^{-2}$ (25 to 100 amps/sq. ft). has been demonstrated for a variety of nickel salt types (see Example 5), different conductive salts, a broad range of agitation levels, and a broad range of Pd/Ni molar concentration ratios which result in the deposition of a broad range of alloy compositions. Also, the iodide addition appears effective over the typical pH range of about 7-9 normally employed in commercial plating baths.

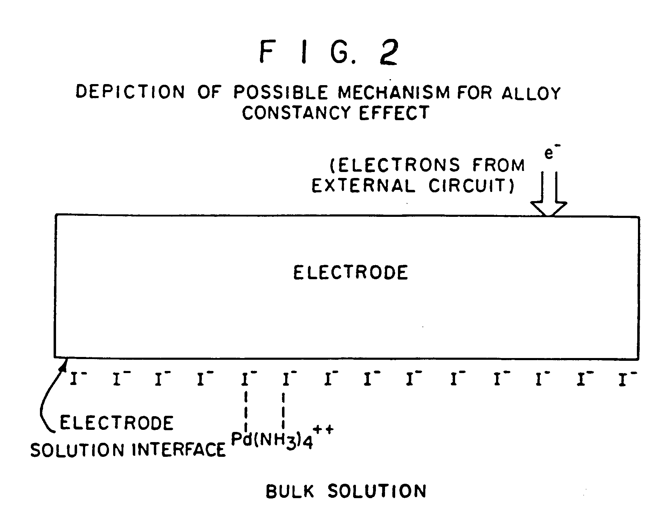

The elements of a possible mechanism to explain this constancy effect on alloy composition are shown in Figure 2. During electroplating, the connector terminal acts as a solid cathode electrode to which the palladium-nickel alloy is to be electroplated. An adsorbed surface layer of iodide ion forms an effective "bridge" for the palladium ion in the bath, probably the $Pd(NH_3)_4^{++}$ ion, to transfer charges to the electrode. The iodide ion, however, does not offer an effective "bridge" to the nickel ion species. This "ligand-bridging" effect has been described in the literature. In essence, such a "bridge" eases the transfer of charge to or from the target ion (in this case, the palladium ion) by both adsorbing on the electrode and also inserting itself into the coordinating sphere of the target ion.

This effect, which is a differential one in that, as stated above, the iodide ion does not offer as effective a bridge for the nickel species as it does for the palladium species, might be written as follows:

1.   $M + X^- \rightarrow M(X^-)_{ads.}$

2.   $M(X^-)_{ads} + Pd(NH_3)_4^{++} \rightarrow [M\cdots X\cdots Pd(NH_3)_3]^+ + NH_3$

3.   $[M\cdots X\cdots Pd(NH_3)_3]^+ + 2e^- \rightarrow Pd^o + 3NH_3 + M(x^-)ads.$

Overall Reaction: $Pd(NH_3)_4^{++} + 2e^- \rightarrow Pd^o + 4NH_3$ at the Cathode

In the above representation, M is the metal cathode electrode, $X^-$ is iodide ion used to obtain the compositional constancy effect and the entity in the brackets represents the bridge formed by the iodide ion between the metal and the palladium species. The kind of coordination represented here is sometimes referred to an "inner sphere" mechanism because at least one ligand is shared, that is, it belongs simultaneously to both coordination shells.

It should also be noted that irrespective of whether one initially adds iodide ions or iodate ions, the electrochemical reactions at the anode and the cathode will continuously recycle these ions. For example, the iodate ion is reduced under cathodic conditions to iodide ion:

$IO_3^- + 3H_2O + 6e^- \rightarrow I^- + 60H^-$

At the anode, the reaction is reversed:

EP 0 335 683 B1

$$I^- + 60H^- \rightarrow IO_3^- + 3H_2O + 6e^-$$

What is important is that iodide ions are available for adsorption at the cathode which is the connector terminal being plated. As explained further below, a thin surface layer of the as-plated terminal surface will in fact contain iodide.

Adsorption of the iodide ion will be facilitated if the cathode is at a potential more positive than its point of zero charge (PZC). At more positive potentials than the PZC, the electrode surface has a net positive charge; at more negative potentials than the PZC, it has a net negative charge.

The above described mechanism is consistent with the observed role of purification in enhancing this effect (see Example 4). Purification, as practiced in the examples in this patent, would tend to remove adsorbable substances from the bath (by virtue of their removal from the palladium source) which might compete with iodide (say, surface-active agents) for sites at the electrode but which would not offer a bridge to the palladium. It is apparent that different substances will vary greatly in the extent to which they will compete with iodide for sites at the surface. Thus, the presently accepted theories of the action of surface-active agents would suggest that more hydrophobic agents would compete more effectively for sites at an electrode surface immersed in an aqueous solution and thus tend to diminish the effectiveness of iodide in maintaining compositional constancy. This is seen in the results for the "pyridinium salt" in which a quantity of this substance in the bath which is far less, on a molar basis, than typical additions of sodium vinyl sulfonate, reduces the effectiveness of the iodide. In fact, its deleterious effect could not be completely overcome by substantial additions of iodide. This finding also indicates that a surface effect is involved since, if the effect were a bulk effect, constancy destabilization induced by the quaternized pyridine should have been "neutralized" by the large additions of iodide. In general, the degree of hydrophobicity can be correlated with the relative quantity of organic character in the molecule in question. Where there is no competition at all from deliberately added substances, the iodide ion alone is more effective in maintaining composition constancy than in the presence of sodium vinyl sulfonate.

Another key property of surface-active agents, aside from their degree of hydrophobicity, which could have a profound effect on their competition with iodide, would be the charge on the surface-active moiety; a positively-charged active moiety might neutralize the iodide effect by creating competition between itself and the palladium ion for iodide.

Since this model depends on at least a surface layer of coverage of iodide on the cathode electrode surface, the optimum concentration of iodide in the bulk solution (whether due initially to addition of iodide ions, iodate ions, or both) may differ under differing conditions of plating, mass transfer, etc.

The presence of a thin adsorbed surface layer containing iodide has been confirmed by X-ray Photoelectron Spectroscopy (XPS) analysis. This technique, which is also referred to as Electron Spectroscopy for Chemical Analysis (ESCA), was used to analyze the surface of the as-plated alloy of palladium and nickel on the cathode as explained in connection with Example 8. XPS analysis shoved the presence of a thin iodide containing surface layer on the palladium-nickel alloy electroplated from baths containing additions of 15 ppm or more of iodide and/or iodate.

XPS analysis is based upon a determination of the binding energy for orbital electrons that are removed from atoms at a surface when the surface is bombarded with soft X-rays. Binding energies of the emitted orbital photoelectrons indicate not only the elements that are present but also the valence state of the elements.

In the XPS analyses of palladium-nickel alloy surfaces electroplated in accordance with the present invention as described in the procedure of Example 8, it was therefore possible to determine whether iodide atoms were present at the surface as iodide or iodate. XPS analysis confirmed that irrespective of whether iodide ions or iodate ions were initially added to the bath, the thin surface layer on the electroplated alloy contained only iodide.

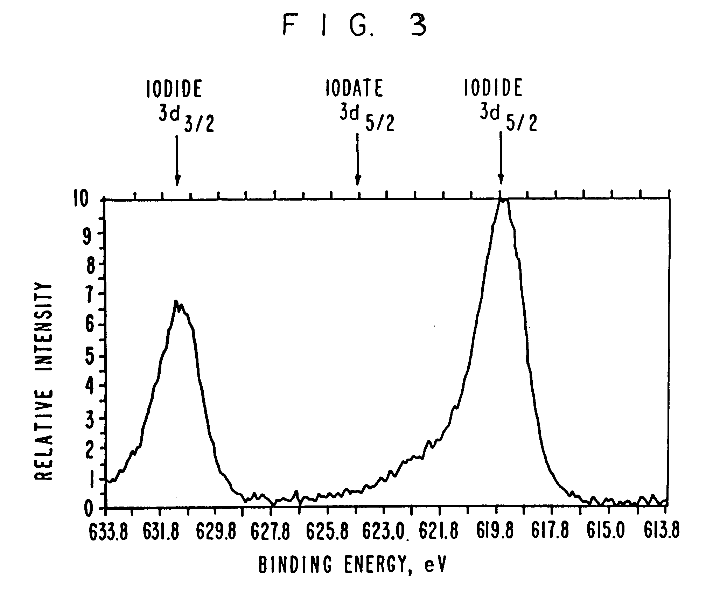

Figure 3 is an XPS profile of iodide 3d peaks detected in analysis of the as-plated surfaces of a disk plated at a current density of 275 $Am^{-2}$ (25 asf) in the presence of iodide. Figure 3 shows the strong iodide peak for the 3d $_{5/2}$ orbital electrons (which have a binding energy of 619 electron volts-eV) and a smaller iodide peak for the 3d $_{3/2}$ orbital electrons (which have a binding energy of 630.5 eV). No peak is evident for iodate which 3d $_{5/2}$ orbital electrons have a binding energy of 624 eV. The XPS profile of Figure 3 is similar to the profiles obtained in the XPS analyses of the other Examples confirming the presence of iodine as iodide atoms in the thin surface layer irrespective of whether iodide ions or iodate ions were initially added to the bath.

XPS can analyze as-plated surfaces to determine composition to a depth of about 2 nm (20 Å) (angstroms) or about 8-10 atomic layers. XPS analysis of plated surfaces showed the presence of iodide on the order of about 10 atomic percent in this 2 nm (20 Å) surface thickness when 15 ppm or more of iodide ions are added to the bath.

While XPS analysis can determine compositions within a 2 nm (20 Å) thickness, it cannot accurately differentiate variations of the composition within such a thin layer. By removing 0.5 nm (5 Å) and 1.5 nm (15 Å) of the surface through sputter removal, it was seen that the iodide appeared to be concentrated within the first 1.5 nm (15 Å) of thickness, and perhaps right at or near the very surface. Thus, while the normalized XPS composition of iodide before sputter removal for the 2 nm (20 Å) depth was 12.6 atomic %, when as little as 0.5 nm (5 Å) was removed, the iodide concentration observable by XPS analysis for the next 2 nm (20 Å) dropped to 3.9 atomic %. Sputter removal of 1.5 nm (15 Å) of the surface layer removed 100% of the iodide. The fact that such a modest amount of sputtering removes all of the iodide is strong evidence that the iodide is concentrated at the outer surface of this 2 nm (20 Å) deep surface layer analyzed by XPS technique. This indicates that the iodide is not incorporated into the bulk of the palladium-nickel alloy coatings during electrodeposition. The iodide remains on the surface of the coating as the alloy coating is electrodeposited where the iodide serves as a ligand bridge to increase the palladium content of the coatings and to maintain its constancy.

EXAMPLES

The following specific examples describe the invention in greater detail. All examples were carried out on copper alloy disks that had been subjected to conventional preplate treatments as practiced in the art. The disks were then electroplated with a pure nickel coating by a conventional nickel sulfamate plating process. The nickel undercoat prevents copper contamination of certain palladium-nickel plating baths, but it is not necessary to the practice of the invention. The nickel-plated surfaces were activated by immersion in a 20 volume % solution of sulfuric acid prior to palladium-nickel alloy plating. Both the nickel plating and the palladium-nickel alloy plating steps were conducted in a conventional rotating-disk-electrode plating apparatus at speeds of rotation ranging from 100 to 500 rpm.

The palladium-nickel alloy coating thicknesses were 1.5 $\mu$m (60 $\mu$in). which is sufficient to permit accurate composition analysis using an Energy-Dispersive X-ray Analysis (EDXA) technique with an accelerating voltage for exciting electrons of 20 kV, which have a depth of analysis of about 1 $\mu$m (40 $\mu$in., or 10,000 Å.) Bulk chemical analyses of coatings by the EDXA technique with appropriate internal standards were used to determine the constancy of palladium-nickel alloy composition with variation in current density which is expressed as the stability parameter $\Delta$ Wt% Pd$_{(100-25)}$.

Example 1 (Comparative)

This example illustrates the typical instability of the composition of palladium-nickel alloys deposited by a process formulated with palladium salts obtained from a variety of commercial sources. Plating baths having the same composition were formulated with palladium salts from six different sources as described in Table I.

Table I

| Plating Run Code | Palladium-Salt Description | |
| --- | --- | --- |
| | Source Code | Salt Type |
| I | A | Tetrammine dichloride |
| II | B | Tetrammine dichloride |
| III | C | Diammine dichloride |
| IV | D | Diammine dichloride |
| V | E | Tetrammine dichloride |
| VI | F | Diammine dichloride |

The plating process composition and plating conditions were as follows:

6

| Bath Chemistry | |
|---|---|
| Pd concentration: | 20 g/l from salts cited in Table I |
| Ni concentration: | 10 g/l as nickel ammine sulfate |
| Sodium vinyl sulfonate: | 2.8 g/l |
| Ammonium sulfate: | 50 g/l |
| Ammonium hydroxide: | Quantity sufficient to achieve desired pH. |

| Plating Conditions | |
|---|---|
| Temperature: | 48°C |
| pH: | 8.5 (adjusted by addition of $NH_4OH$ or HCl) |
| Speed of disk rotation: | 500 rpm |

Disks were plated with palladium-nickel alloy coatings at current densities ranging from 275-2200 $Am^{-2}$ (25 to 200 amp/sq.ft). from six baths of the composition cited above, each bath being formulated with one of the six different palladium salts cited in Table I. The results of coating alloy compositions analyses appear in Table II. The alloy composition stability parameter [$\Delta$ Wt% $Pd_{(100-25)}$] for the six plating baths ranged from 13.0 to 18.7.

Table II

| Plating Run Code | Plated Pd-Ni Alloy Composition in Weight % Pd* at Indicated Current Density | | | | $\Delta$ Wt% $Pd_{(100-25)}$ |
|---|---|---|---|---|---|
| | 25 asf | 50 asf | 75 asf | 100 asf | |
| | 275 $Am^{-2}$ | 550 $Am^{-2}$ | 82×5 $Am^{-2}$ | 1100 $Am^{-2}$ | |
| I | 67.3 | 77.3 | - | 84.3 | 17.0 |
| II | 74.3 | 80.8 | - | 87.3 | 13.0 |
| III | 69.5 | 77.4 | 80.3 | 83.8 | 14.3 |
| IV | 66.3 | 76.2 | 79.8 | 83.4 | 17.1 |
| V | 63.4 | 75.0 | - | 82.1 | 18.7 |
| VI | 62.4 | 66.4 | 75.6 | 80.2 | 17.8 |

*Note:
Balance, nickel.

Example 2 (Comparative)

Palladium-nickel alloy coatings were electrodeposited on disks at current densities ranging from 275-2200 $Am^{-2}$ (25 to 200 asf) using the bath chemistry and plating conditions set forth below:

| Bath Chemistry | |
|---|---|
| Pd concentration: | 17.0 g/l as palladous tetrammine dichloride |
| Ni concentration: | 11.0 g/l as nickel ammine chloride |
| Sodium vinyl sulfonate: | 2.8 g/l |
| Ammonium sulfate: | 50 g/l |
| Ammonium hydroxide: | Quantity sufficient to achieve desired pH. |

| Plating Conditions | |
| --- | --- |
| Temperature: | 48 °C |
| pH: | 8.0 |
| Speed of rotation: | 500 rpm |

Results for coating composition analyses as a function of current density appear in Table III. The process had a $\Delta$ Wt% $Pd_{(100-25)}$ parameter of 21.4.

Table III

| Am$^{-2}$ | Current Density (asf) | Pd-Ni Alloy Composition | |
| --- | --- | --- | --- |
| | | Wt% Pd | Wt% Ni |
| 275 | 25 | 47.3 | 52.7 |
| 550 | 50 | 54.9 | 45.1 |
| 825 | 75 | 62.5 | 37.5 |
| 1100 | 100 | 68.7 | 31.3 |
| 2200 | 200 | 77.0 | 23.0 |

Example 3 (Comparative)

Palladium-nickel alloy coatings were electrodeposited on disks at current densities ranging from 275-2200 Am$^{-2}$ (25 to 200 asf) using the bath chemistries and plating conditions set forth below:

| Bath Chemistry | |
| --- | --- |
| Pd concentration: | 15.0 g/l as palladous tetrammine dichloride |
| Ni concentration: | 7.5 g/l as nickel chloride |
| "Pyridinium salt": | 0.6 g/l |
| Ammonium chloride: | 30 g/l |
| Ammonium hydroxide: | Quantity sufficient to achieve desired pH. |

| Plating Conditions | |
| --- | --- |
| Temperature: | 48 °C |
| pH: | 8.5 |
| Speed of rotation: | 500 rpm |

Results for coating composition analyses as a function of current density appear in Table IV. The process had a $\Delta$ Wt% $Pd_{(100-25)}$ of 16.9.

Table IV

| Am$^{-2}$ | Current Density (asf) | Pd-Ni Alloy Composition | |
| --- | --- | --- | --- |
| | | Wt%Pd | Wt%Ni |
| 275 | 25 | 64.5 | 35.5 |
| 550 | 50 | 72.1 | 27.9 |
| 825 | 75 | 77.4 | 22.6 |
| 1100 | 100 | 81.4 | 18.6 |
| 2200 | 200 | 84.2 | 15.8 |

Example 4 (Comparative)

This example illustrates the beneficial effect of iodide ion addition and palladium salt purification on the constancy of the composition of electrodeposited palladium-nickel alloys. A sample of palladous tetrammine chloride salt was purified through one recrystallization cycle as described earlier. Palladium-nickel alloys were plated on disks at current densities ranging from 275-1100 $Am^{-2}$ (25 to 100 asf) using a bath chemistry and plating conditions set forth below:

| Bath Chemistry | |
|---|---|
| Pd concentration: | 20 g/l |
| Ni concentration: | 10 g/l as nickel ammine sulfate |
| Sodium vinyl sulfonate: | 2.8 g/l |
| Iodide ion: | 31 ppm |
| Ammonium sulfate: | 50 g/l |
| Ammonium hydroxide: | Quantity sufficient to achieve desired pH. |

| Plating Conditions | |
|---|---|
| Temperature: | 48°C |
| pH: | 8.5 |
| Speed of rotation: | 500 rpm |

The $\Delta$ Wt% $Pd_{(100-25)}$ for the process was 4.2.

Example 5 (Comparative)

Palladium-nickel alloy coatings were electrodeposited on disks at current densities ranging from 275-1100 $Am^{-2}$ (25 to 100 asf) under identical operating conditions from baths that were formulated with three different types of nickel salts, an ammine sulfate, a sulfate, and a chloride. The palladium salt, other basic process chemistry parameters, and plating conditions were identical to those for Example 4. The constancy of palladium alloy composition for the three different types of nickel salt appear in Table V.

Table V

| Nickel Salt Type | $\Delta$ Wt% $Pd_{(100-25)}$ |
|---|---|
| Ammine sulfate | 4.2 |
| Sulfate | 2.8 |
| Chloride | 2.3 |

Example 6

This example illustrates the beneficial effect of iodate ion additions in significantly improving the constancy of palladium-nickel alloy composition electrodeposited from baths containing sodium vinyl sulfonate as an organic brightener. All baths were formulated with the same lot of a commercially available palladium diammine dichloride salt. Palladium-nickel alloy coatings were electrodeposited onto disks at current densities ranging from 275-1100 $Am^{-2}$ (25 to 100 asf) from baths containing 0, 15 and 100 ppm of iodate ions added as the sodium salt. The basic chemistry and plating conditions were as follows:

9

**EP 0 335 683 B1**

| Bath Chemistry | |
|---|---|
| Pd concentration: | 20 g/l as palladium diammine dichloride |
| Ni concentration: | 10 g/l as nickel ammine sulfate |
| Sodium vinyl sulfonate: | 2.8 g/l |
| Ammonium sulfate: | 50 g/l |
| Ammonium hydroxide: | quantity sufficient to achieve desired pH |

| Plating Conditions | |
|---|---|
| Temperature: | 48 °C |
| pH: | 8.5 |
| Speed of disk rotation: | 500 rpm |

Coating composition analyses as a function of current density and iodate ion addition level appear in Table VI. The process without an addition of iodate ions had a $\Delta$ Wt% $Pd_{(100-25)}$ stability parameter of 16.7; whereas, the $\Delta$ Wt% $Pd_{(100-25)}$ for the process with 100 ppm of iodate ions was only 4.2.

Table VI

| Iodate Ion Addition ppm | Plated Pd-Ni Alloy Composition in Weight % Pd* at Indicated Current Density | | | $\Delta$ Wt% Pd |
|---|---|---|---|---|
| | 25 asf | 50 asf | 100 asf | |
| | $275\ Am^{-2}$ | $550\ Am^{-2}$ | $1100\ Am^{-2}$ | |
| 0 | 67.9 | 76.5 | 84.6 | 16.7 |
| 15 | 80.2 | 84.5 | 88.0 | 7.8 |
| 100 | 81.1 | 83.2 | 85.3 | 4.2 |

*NOTE:
Balance nickel.

Example 7

This example illustrates the beneficial effect of iodate ion addition to a palladium-nickel plating bath with no organic brighteners in promoting constancy of alloy composition. Baths were formulated with the same lot of palladium diammine dichloride that was used in Example 6. Palladium-nickel alloy coatings were electrodeposited onto disks at current densities ranging from $275-1100\ Am^{-2}$ (25 to 100 asf) from baths containing 15 and 100 ppm of iodate ions added as the sodium salt. The basic bath composition and operating conditions were as follows:

| Bath Chemistry | |
|---|---|
| Pd concentration: | 20 g/l as palladium diammine dichloride |
| Ni concentration: | 10 g/l as nickel ammine sulfate |
| Ammonium sulfate: | 50 g/l |
| Ammonium hydroxide: | quantity sufficient to achieve desired pH |

| Plating Conditions | |
| --- | --- |
| Temperature: | 48 °C |
| pH: | 8.5 |
| Speed of dish rotation: | 500 rpm |

The $\Delta$ Wt% Pd$_{(100-25)}$ for the bath with the 15 ppm addition of iodate ions was 7.6 and that for the bath with a 100 ppm addition of iodate ions was 5.8. All coatings had a bright, mirror-like appearance indicating the iodate ions were performing the function of a brightener as well as that of a stabilizer of plated alloy composition.

In the following Example 8 X-ray Photoelectron Spectroscopy (XPS) was used to detect and analyze the unique structure of a layer of iodide atoms on the outer surface of the plated palladium-nickel alloy.

The XPS technique analyzes to a depth of only 2 nm (20 Å) or about 8 to 10 atomic layers. XPS analyses are typically expressed in atomic percent. The surface composition of the coatings cited in Example 8 was determined on a Perkin-Elmer Phi® 5400 ESCA System using their Multiplex analysis program. The XPS conditions for all analyses were as follows:

| | |
| --- | --- |
| Type of X-ray Radiation: | Mg K (1253.6 eV) |
| Accelerating Voltage: | 15 kV |
| Tube Power Setting: | 300 Watts |
| Take-off Angle: | 45 ° |

The XPS technique can be combined with a sputtering technique wherein surface atoms ore removed (by bombardment with argon ions) to analyze compositions below the original surface of the as-plated disk. The rates of removal are ordinarily quantified by correlating with established rates such as on $SiO_2$ (our method) or $Ta_2O_5$.

Example 8

This example shows that the beneficial effect of an iodate ion addition to a palladium-nickel alloy plating bath in promoting constancy of a plated alloy composition is associated with the formation of a layer of iodide on the surface. All baths were formulated with the same lot of palladium diammine dichloride such as used in Examples 4 and 5. Palladium-nickel alloy coatings were electrodeposited on disks at current densities ranging from 275-1100 Am$^{-2}$ (25 to 100 asf) from baths containing 15. 30, and 100 ppm iodate ions added as the sodium salt. The basic bath chemistry and plating conditions were as follows:

| Bath Chemistry | |
| --- | --- |
| Pd concentration: | 20 g/l as palladium diammine dichloride |
| Ni concentration: | 10 g/l as nickel ammine sulfate |
| Ammonium sulfate: | 50 g/l |
| Ammonium hydroxide: | Quantity sufficient to achieve desired pH |

| Plating Conditions | |
| --- | --- |
| Temperature: | 48 °C |
| pH: | 8.5 |
| Speed rotation: | 500 rpm |

The $\Delta$ Wt% Pd$_{(100-25)}$ stability factor based on EDXA of bulk alloy coating composition to a depth of 1 $\mu$m (10,000 Å) appears in Table VII.

TABLE VII

| Iodide Ion Addition ppm | $\Delta$ Wt% Pd$_{(100-25)}$ |
|---|---|
| 15 | 7.6 |
| 30 | 7.4 |
| 100 | 5.8 |

The results of XPS analyses of the palladium-nickel alloy surface composition to a depth of 2 nm 20 A, on disks plated at a current density of 275 Am$^{-2}$ (25 asf.) are summarized in Table VIII.

Table VIII

| Iodate Addition ppm | Normalized XPS Compositions of As-plated Pd-Ni Alloy Surface (Atomic %) | | |
|---|---|---|---|
| | Pd | Ni | I |
| 15 | 65.9 | 22.8 | 11.3 |
| 30 | 61.6 | 26.5 | 11.8 |
| 100 | 66.7 | 23.0 | 10.3 |

While the above description and attached drawings illustrate certain embodiments of the present invention, it will be apparent that other embodiments and modifications may be made that are equivalent thereto to one skilled in the art. For example, combinations of iodide and iodate ion additions are also within the scope of this invention. The alloy coatings may be electroplated on a number of substrates including, but not limited to, electrical contacts and terminals of connector assemblies, printed circuit boards and other circuit substrates, as well as on jewelry and the like as decorative coatings.

## Claims

1. An electroplating bath for plating a coating of palladium-nickel alloy on an electrically conductive substrate the bath comprising a palladium salt, a nickel salt and at least 15 parts per million of iodate ions.

2. A bath as claimed in claim 1 further including a conductive salt and having a pH in the range of 7 to 9.

3. A bath as claimed in claim 1 or claim 2 wherein
   i. the palladium salt is palladium II ammine chloride,
   ii. the nickel salt is selected from nickel ammine sulfate, nickel sulfate and nickel chloride.

4. A bath as claimed in claim 3 further comprising an organic brightener.

5. A bath as claimed in claim 4 wherein the brightener is sodium vinyl sulfonate.

6. A bath as claimed in any one of the preceding claims further comprising iodide ions.

7. A method of electroplating comprising the steps of:
   a) immersing an electrically conductive substrate in an electroplating bath as claimed in any one of the preceding claims, and
   b) applying plating current to the bath wherein the plating current is in the range of 110 Am$^{-2}$ (10 asf) to 1650 Am$^{-2}$ (150 asf).

8. A method as claimed in claim 7 wherein the current density is in the range of 275 Am$^{-2}$ (25 asf) to 1100 Am$^{-2}$

9. A method as claimed in claim 7 or claim 8 wherein the current density on the conductive substrate varies by as much as a factor of four.

**10.** A method as claimed in any one of claims 7,8 or 9 wherein the plating current is applied until the coating comprises;

a) a first layer comprising an alloy of palladium and nickel electroplated on the substrate, and

b) a second layer up to 2 $\mu$m thick at the surface of the first layer comprising iodide and an alloy of palladium and nickel.

**11.** A method as claimed in any one of claims 7,8,9 or 10 wherein the substrate is an electrical terminal or a circuit board.

**Patentansprüche**

**1.** Elektroplattierungsbad zur Plattierung eines Überzugs aus einer Palladium-Nickel-Legierung auf ein elektrisch leitendes Substrat, wobei das Bad umfaßt ein Palladiumsalz, ein Nickelsalz und mindestens 15 ppm Iodat-Ionen.

**2.** Bad nach Anspruch 1, das außerdem ein leitendes Salz enthält und einen pH-Wert im Bereich von 7 bis 9 aufweist.

**3.** Bad nach Anspruch 1 oder Anspruch 2, worin

i. das Palladiumsalz Palladium(II)-aminchlorid darstellt,

ii. das Nickelsalz ausgewählt ist aus Nickelaminsulfat, Nickelsulfat und Nickelchlorid.

**4.** Bad nach Anspruch 3, welches weiterhin einen organischen Aufheller enthält.

**5.** Bad nach Anspruch 4, worin der Aufheller Natriumvinylsulfonat darstellt.

**6.** Bad nach einem der vorausgegangenen Ansprüche, welches weiterhin Iodid-Ionen enthält.

**7.** Verfahren zur Elektroplattierung, umfassend die Stufen:

a) Eintauchen eines elektrisch leitenden Substrats in ein Elektroplattierungsbad nach einem der vorausgegangenen Ansprüche, und

b) Anwenden eines Plattierungsstromes auf das Bad, in dem der Plattierungsstrom im Bereich von 110 Am$^{-2}$ (10 asf) bis 1 650 Am$^{-2}$ (150 asf) liegt.

**8.** Verfahren nach Anspruch 7, bei dem die Stromdichte im Bereich von 275 Am$^{-2}$ (25 asf) bis 1 100 Am$^{-2}$ (100 asf) liegt.

**9.** Verfahren nach Anspruch 7 oder Anspruch 8, bei dem die Stromdichte auf dem elektrisch leitenden Substrat um so viel wie um den Faktor 4 variiert.

**10.** Verfahren nach einem der Ansprüche 7, 8, oder 9, bei dem der Plattierungsstrom angewendet wird, bis der Überzug folgendes umfaßt

a) eine erste Schicht, die eine auf das Substrat elektroplattierte Legierung aus Palladium und Nickel enthält, und

b) eine zweite Schicht einer Dicke bis zu 2 $\mu$m auf der Oberfläche der ersten Schicht, die Iodid und eine Legierung aus Palladium und Nickel enthält.

**11.** Verfahren nach einem der Ansprüche 7,8,9 oder 10, bei dem das Substrat einen elektrischer Abschluß oder eine Schalttafel darstellt.

**Revendications**

**1.** Bain de dépôt électrolytique pour le plaquage d'un revêtement d'alliage de palladium-nickel sur un substrat conducteur l'électricité, le bain comprenant un sel de palladium, un sel de nickel et au moins 15 parties par million d'ions iodate.

**2.** Bain selon la revendication 1, comprenant de plus un sel conducteur et ayant un pH compris entre 7 et 9.

13

3. Bain selon les revendications 1 ou 2, dans lequel:
   (i) le sel de palladium est le chlorure de palladium (II) amine,
   (ii) le sel de nickel est choisi parmi le sulfate de nickel amine, le sulfate de nickel et le chlorure de nickel.

4. Bain selon la revendication 3, comprenant de plus un agent lustrant organique.

5. Bain selon la revendication 4, dans lequel l'agent lustrant organique est le vinyl sulfonate de sodium.

6. Bain selon l'une quelconque des revendications précédentes, comprenant de plus des ions iodure.

7. Procédé pour réaliser un dépôt électrolytique, comprenant les étapes de:
   (a) immersion d'un substrat conducteur dans un bain de dépôt électrolytique suivant l'une quelconque des revendications précédentes, et
   (b) application d'un courant de plaquage au bain dans lequel la densité du courant se trouve dans la gamme de 110 à 1650 $Am^{-2}$ (10 à 150 A/ft$^2$, asf).

8. Procédé selon la revendication 7, dans lequel la densité de courant est dans la gamme de 275 à 1100 $Am^{-2}$ (25 à 100 asf).

9. Procédé selon les revendications 7 ou 8, dans lequel la densité de courant sur le substrat conducteur varie d'un facteur allant jusqu'à quatre.

10. Procédé selon l'une quelconque des revendications 7, 8 ou 9, dans lequel le courant de plaquage est appliqué jusqu'au moment où le revêtement comprend:
    (a) une première couche comprenant un alliage de palladium et de nickel déposé électrolytiquement sur le substrat, et
    (b) une seconde couche ayant jusqu'à 2 $\mu$m d'épaisseur à la surface de la première couche comprenant de l'iodure et un alliage de palladium et de nickel.

11. Procédé selon l'une quelconque des revendications 7, 8, 9 ou 10, dans lequel le substrat est une extrémité électrique ou une plaque de circuits.

# F I G. 1

$\Delta$ Wt % Pd$_{(100-25)}$ = 18.7

—□— CURVE A UNSTABLE PROCESS

—△— CURVE B STABLE PROCESS

WEIGHT % PALLADIUM

CURRENT DENSITY (ASF)

# F I G. 2

## DEPICTION OF POSSIBLE MECHANISM FOR ALLOY CONSTANCY EFFECT

(ELECTRONS FROM EXTERNAL CIRCUIT) $e^-$

ELECTRODE

$I^-$ $I^-$ $I^-$ $I^-$ $I^-$ $I^-$ $I^-$ $I^-$ $I^-$ $I^-$ $I^-$ $I^-$ $I^-$ $I^-$

ELECTRODE SOLUTION INTERFACE $Pd(NH_3)_4^{++}$

BULK SOLUTION

16

F I G. 3

EP 0 335 683 B1